# EUROPEAN PATENT APPLICATION

(11) **EP 4 683 037 A1**
(43) Date of publication of application: **21.01.2026**
(21) Application number: 24872808.1
(22) Date of filing: 13.09.2024
(51) Int. Cl.: H01M 10/44, H02J 7/00, G01R 31/387, H01M 4/134, H01M 10/052, H01M 4/02, H01M 10/42

(54) **METHOD AND APPARATUS FOR CHARGING BATTERY**

(30) Priority: 27.09.2023 KR 20230130165
(71) Applicant: LG Energy Solution, Ltd., Seoul 07335 (KR)
(72) Inventor: CHOI, Dong-In, Daejeon 34122 (KR); PARK, Tae-Soon, Daejeon 34122 (KR); MIN, Ji-Won, Daejeon 34122 (KR)
(74) Representative: Goddar, Heinz J.
(86) International application number: PCT/KR2024/013960
(87) International publication number: WO 2025/071100

(57) **Abstract**

A method for charging a battery according to an embodiment of the present disclosure is a method for charging a battery by dividing a charging section into a plurality of charging sections, and includes a first charging step for charging the battery in an nth (n is a natural number) charging section; a first rest step having a rest period for a first time after the first charging step is terminated; a second charging step for charging the battery in an n+1th charging section; and a second rest step having a rest period for a second time after the n+1th charging section is terminated.

## Description

### TECHNICAL FIELD

The present application claims priority to Korean Patent Application No. 10-2023-0130165 filed on September 27, 2023 in the Republic of Korea, the disclosures of which are incorporated herein by reference.

The present disclosure relates to a method and apparatus for charging a battery, and more specifically, to a method and apparatus for charging a battery, which may improve intrinsic performance and lifespan of a battery.

### BACKGROUND ART

As the demand for portable electronic products such as laptops, video cameras, and mobile phones that use electricity as a power source increases rapidly, and as mobile robots, electric bicycles, electric carts, and electric vehicles become more widely commercialized, research on high-performance secondary batteries that can be repeatedly charged and discharged is actively being conducted.

Commercialized secondary batteries include nickel-cadmium batteries, nickel-metal hydride batteries, nickel-zinc batteries, and lithium secondary batteries. Among them, lithium secondary batteries have the advantage of being free to charge and discharge and having a very low self-discharge rate compared to nickel-based secondary batteries, due to almost no memory effect. In addition, lithium secondary batteries have the characteristics of high energy density and high operating voltage, and thus are being studied more intensively than other types of secondary batteries and are being applied more widely in actual products.

Recently, secondary batteries are widely used not only in small devices such as portable electronic devices, but also in medium and large-sized devices such as electric vehicles and energy storage systems (ESSs).

In this case, a battery module in which a number of electrically connected secondary batteries are stored together inside a module case is mainly applied, and furthermore, when high power or large capacity is required, a battery pack in which a number of such battery modules are electrically connected is also applied.

Various studies are being conducted on battery charging, such as quick charging, to more effectively reflect users' needs on batteries and improve the overall environment due to the high capacity of batteries.

The methods used to charge batteries include constant current-constant voltage (CC-CV) charging, pulse charging, boost charging, and multi-step CC charging.

When charging a battery in a high current environment to shorten the charging time, a lithium plating (Li-plating) phenomenon may occur in which lithium cations (Li⁺) supplied to the negative electrode are not quickly absorbed by the negative electrode and accumulate on the negative electrode and are precipitated as lithium metal.

Meanwhile, for positive electrode materials, technology development is being conducted to increase the proportion of nickel in order to improve the energy density of secondary batteries, and for negative electrode materials, research and development is being conducted on silicon (Si), silicon oxide (SiOx), tin (Tin, Sn), etc., which have high-capacity characteristics, as substitutes or complementary materials (supplements) to graphite, the main material of conventional negative electrode materials, in order to increase quick charging efficiency and lifespan. Research is also being conducted to form a negative electrode using only pure Si, SiOx, and Sn compositions.

A negative electrode having this composition has the advantage of being able to significantly shorten the charging time because the electrode thickness is thin and the lithiation method is different from that of graphite. In addition, in the case of active materials such as silicon (Si), silicon oxide (SiOx), and tin (Sn), the potential during charging is higher than that of graphite-based negative electrode materials, so there is a low possibility of lithium precipitation on the surface of the active material during quick charging.

However, in the case of a negative electrode having such a composition, only the active material adjacent to the separator is mainly used for quick charging and deteriorates, so there is a relatively high possibility that performance deterioration and lifespan reduction will occur as the charging cycle progresses.

Therefore, in the case of a battery having a negative electrode having Si, SiOx, and Sn compositions, there is a great need to apply a new charging method that may faithfully reflect the above-described characteristics.

### DISCLOSURE

### Technical Problem

The present disclosure is designed to solve the problems of the related art, and therefore the present disclosure is directed to providing a method and apparatus for charging a battery, which may increase the charging efficiency and further improve the performance and lifespan of a battery according to the discharge cycle by providing a predetermined rest period after the charging of a current charging section is completed before a next charging section starts so that a charging section divided into a plurality of sections is performed intermittently, and by increasing the length (time) of the rest period as the charging section progresses.

The technical problems to be solved by the present disclosure are not limited to the above, and other problems not mentioned herein will be clearly understood by those skilled in the art from the following description.

### Technical Solution

A method for charging a battery according to an aspect of the present disclosure is a method of charging a battery by dividing a charging section into a plurality of charging sections, and may include a first charging step for charging the battery in an nth (n is a natural number) charging section; a first rest step having a rest period for a first time after the first charging step is terminated; a second charging step for charging the battery in an n+1th charging section; and a second rest step having a rest period for a second time after the n+1th charging section is terminated.

The second time may be set differently from the first time.

The second time may be set to be a longer time than the first time.

A charging rate of the n+1th charging section may be set to be lower than a charging rate of the nth charging section.

Each of the charging steps may further include a characteristic value calculating step for calculating a current SOC of the battery; a section determining step for determining an initiation section, which is a charging section corresponding to the current SOC, among the plurality of charging sections; and a charging initiating step for initiating charging of the battery with a charging environment of the initiation section.

Each of the charging steps may be set to be terminated when a voltage of the battery reaches a reference voltage preset for the corresponding charging section.

The method for charging a battery according to one aspect of the present disclosure may be configured to be terminated when a voltage of the battery reaches a preset full-charge voltage.

The battery may be a battery with a negative electrode of Si-based composition.

An apparatus for charging a battery according to another aspect of the present disclosure may comprise a charging unit configured to charge a battery; a blocking unit configured to block charging of the battery; and a control unit configured to control the charging unit so that the battery is charged with a plurality of charging sections.

The control unit may be configured to control the blocking unit such that a rest period is included between the plurality of charging sections.

The control unit may be configured to control the blocking unit so that an n+1th (where n is a natural number) rest period is longer than an nth rest period.

The control unit may include a characteristic value calculating part for calculating a current SOC of the battery; an attribute information storing part for storing attribute information of the plurality of charging sections; a section determining part for determining an initiation section, which is a charging section corresponding to the current SOC, using the attribute information; and a main control part for controlling the charging unit so that charging of the battery is initiated with a charging environment of the initiation section.

### Advantageous Effects

According to the present disclosure, lithium densely packed on the electrode due to charging may be induced to move downward through a spontaneous reaction that resolves the concentration gradient, so that the phenomenon of degradation being concentrated in a specific area may be effectively alleviated or reduced. Through this, the operating performance and durability of the battery according to the charging cycle may be further improved.

In addition, according to the present disclosure, the rest period applied between charging sections may be lengthened as charging progresses, thereby suppressing battery deterioration and improving charging time efficiency.

Furthermore, according to the present disclosure, a charging environment more optimized for a battery having a negative electrode of Si composition, which is not easy to move lithium ions due to high current density and volume expansion of the active material, may be implemented.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram showing a detailed configuration of an apparatus for charging a battery according to an embodiment of the present disclosure.
FIG. 2 is a block diagram showing the detailed configuration of a control unit illustrated in FIG. 1.
FIG. 3 is a flowchart showing a charging processing process according to an embodiment of the present disclosure.
FIG. 4 is a flowchart showing a charging processing process according to another embodiment of the present disclosure.
FIG. 5 is a drawing showing an example of a rest period in which the application time is differentiated.
FIG. 6 is a drawing showing an example of a charging rate for each charging section.
FIG. 7 is a drawing showing the time-series characteristics of the charging rate and rest period based on the entire charging process.
FIG. 8 is a drawing showing the performance results of a battery according to an embodiment of the present disclosure based on the discharge capacity retention.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

Throughout the specification, when a portion is referred to as "comprising" or "including" any element, it means that the portion may include other elements further, without excluding other elements, unless specifically stated otherwise.

Furthermore, the term "processor" described in the specification refers to a unit that processes at least one function or operation, and may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

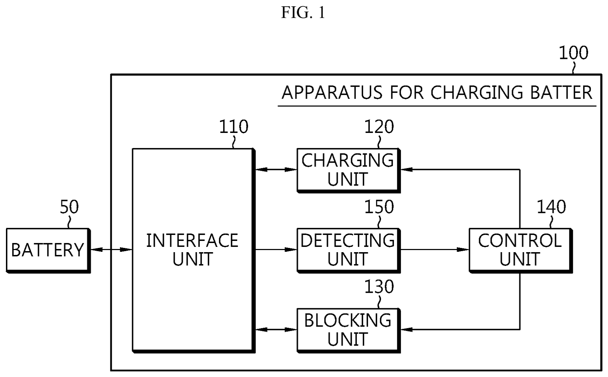

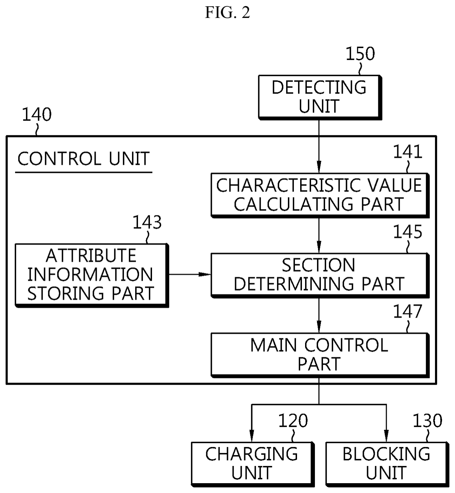

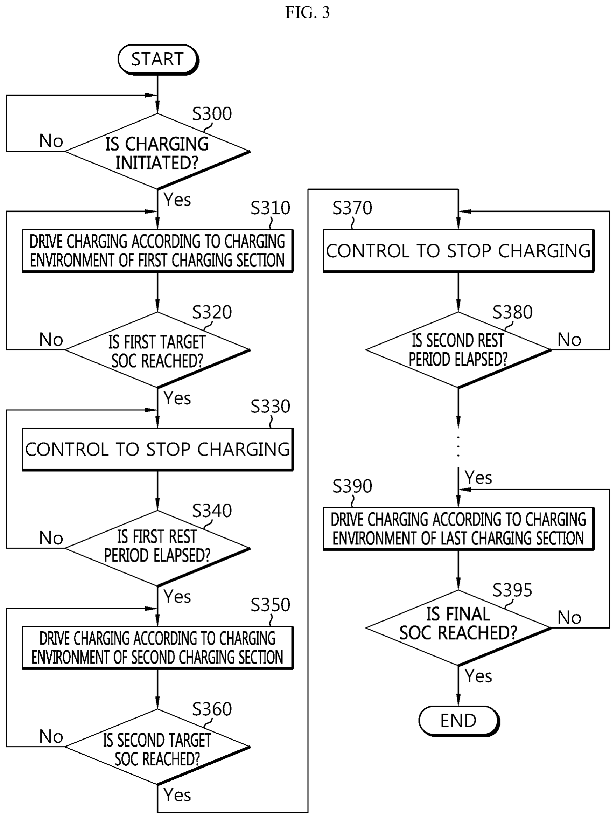

FIG. 1 is a block diagram showing a detailed configuration of an apparatus for charging a battery according to an embodiment of the present disclosure. FIG. 2 is a block diagram showing the detailed configuration of a control unit illustrated in FIG. 1. FIG. 3 is a flowchart showing a charging processing process according to an embodiment of the present disclosure.

First, with reference to FIG. 1 and related drawings, etc., the detailed configuration of the apparatus 100 for charging a battery according to the present disclosure and the processing performed by the configuration will be described in detail.

As illustrated in FIG. 1, the apparatus for charging a battery 100 of the present disclosure may be configured to include an interface unit 110, a charging unit 120, a blocking unit 130, a control unit 140, and a detecting unit 150.

Prior to the detailed description of the present disclosure, the apparatus for charging a battery 100 according to the present disclosure may be implemented through various combinatorial applications of electronic components, parts, etc., such as storage means, operation processing means, and input/output means (ASIC, chipset, logic circuit, register, communication modem, MCU, etc.).

Therefore, each component of the apparatus for charging a battery 100 illustrated in FIG. 1 should be understood as a functionally or logically distinct component rather than a physically distinct component.

That is, since each component depicted in the drawings corresponds to a logical structure for effectively explaining the technical idea by the present disclosure, even if each component is configured integrated or separately, if the function performed by the logical structure of the present disclosure can be realized, it should be interpreted as being within the scope of the present disclosure, and if it is a component that performs the same or similar function, it should of course be interpreted as being within the scope of the present disclosure regardless of the consistency in their names. The same applies to the control unit 140 illustrated in FIG. 2.

In addition, the method for charging a battery of the present disclosure may be implemented as a set of processing or algorithm for data processing, handling, control, calculation, etc. as a whole, and thus, it may be implemented by a combination of the logical configurations shown in FIG. 1, as well as in the form of software installed and operated on a computer or a terminal, module, etc. equivalent thereto.

The charging unit 120 is electrically connected to the battery 50 and performs charging processing for the battery 50. According to an embodiment, the charging unit 120 may be electrically connected to the battery 50 through the interface unit 110 as illustrated in FIG. 1. Here, the interface unit 110 may be configured as a jack or socket and electrically connect the battery 50 and the apparatus 100 for charging a battery.

Here, since various cell assemblies such as battery cells, battery banks, battery modules, and battery packs may be targets of charging, the battery 50 in the following description may mean an object that collectively refers to cell assemblies. Hereinafter, the target of charging is referred to as 'battery'.

Specifically, the operating state of the charging unit 120 may be controlled by the control unit 140. For example, the charging unit 120 may charge the battery by applying a charging current to the battery under the control of the control unit 140.

The blocking unit 130 is configured to induce a rest period during the charging processing of the present disclosure that proceeds with a plurality of charging sections by stopping or blocking the charging processing performed by the charging unit 120 through a relay, a switch, or the like.

According to the embodiment, the blocking unit 130 may be implemented in an integrated form with the charging unit 120, and may also be implemented as a circuit configuration for turning on and off the electrical connection between the charging power source and the battery 50 within the interface unit 110.

Specifically, the operating state of the blocking unit 130 may be controlled by the control unit 140. For example, the blocking unit 130 may block the charging of the battery under the control of the control unit 140.

The control unit 140 may be communicatively connected to the charging unit 120 and the blocking unit 130. In addition, the control unit 140 may be configured to control the charging processing performed by the charging unit 120 and the blocking processing performed by the blocking unit 130.

The apparatus for charging a battery 100 according to the present disclosure is configured to charge the battery 50 by dividing the charging section into k sections (k is a natural number greater than or equal to 3) without performing continuous charging processing from the start of charging to the end of charging (hereinafter, referred to as 'multi-step charging mode').

The control unit 140 may charge the battery 50 by dividing the charging section into a plurality of charging sections.

For example, the control unit 140 may perform a first charging step for charging the battery in the nth (where n is a natural number) charging section. That is, the control unit 140 may control the charging unit 120 to charge the battery 50 in the nth charging section. Further, the control unit 140 may perform a first rest step to have a rest period during the first time after the first charging step is terminated. That is, the control unit 140 may control the blocking unit 130 to allow the battery 50, which has completed the first charging step, to have a rest period during the first time. Similarly, the control unit 140 may perform a second charging step for charging the battery in the n+1th charging section. That is, the control unit 140 may control the charging unit 120 to charge the battery 50 in the n+1th charging section. Further, the control unit 140 may perform a second rest step to have a rest period during the second time after the second charging step is terminated. That is, the control unit 140 may control the blocking unit 130 so that the battery 50, which has completed the second charging step, may have a rest period during the second time.

For example, if the charging processing includes a total of five charging sections, it may be configured to have four rest periods, excluding the last charging section where charging is terminated. That is, five charging steps and four rest steps may be performed in the charging process of the battery 50.

In addition, according to a preferred embodiment of the present disclosure, the time (second time) of a subsequent rest period is configured to be longer than the time (first time) of a preceding rest period based on the order in which charging is performed.

Meanwhile, it goes without saying that the charging environment including the charging rate and charging time may be individually set for each charging section depending on the embodiment.

The control unit 140 may initiate charging of the battery 50 when the battery 50 and the charging unit 120 are physically connected (S300).

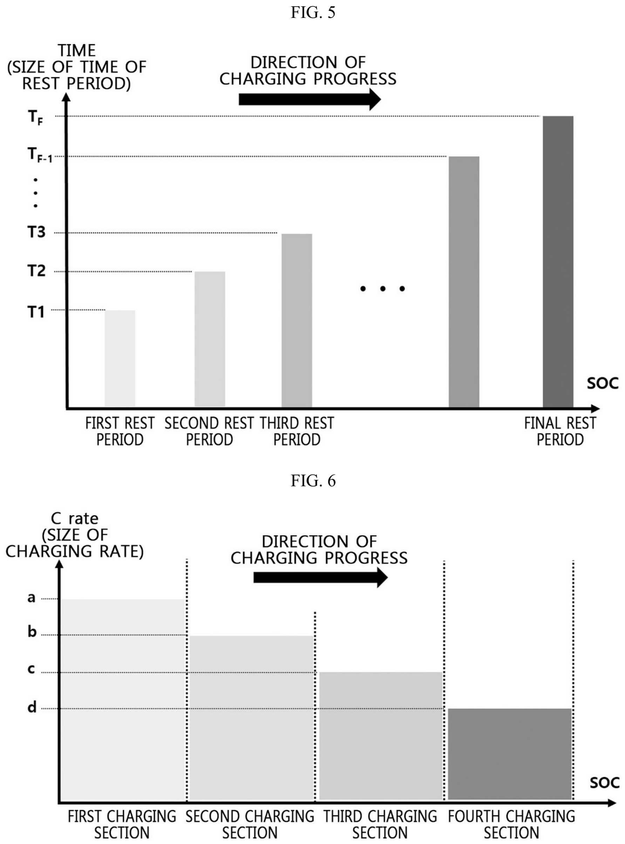

The control unit 140 may control the charging unit 120 to drive charging according to the charging environment of the first charging section (S310). Here, the charging environment means one or more of the time at which charging is performed, that is, the length of the corresponding charging section (min, etc.), the size of the charging current (mA or A), and the charging rate (C-rate). Considering the charging efficiency, the possibility of degradation, etc., it is preferable that the size of the charging current or the charging rate is set to decrease as it goes to the subsequent charging section. For example, in the embodiment of FIG. 6, the size of the charging rate of the first charging section is a, the size of the charging rate of the second charging section is b, the size of the charging rate of the third charging section is c, and the size of the charging rate of the fourth charging section is d. Preferably, the sizes of the charging rates of the first charging section to the fourth charging section may be set to "a > b > c > d".

The control unit 140 may determine whether the SOC of the battery 50 reaches the first target SOC by charging of the first charging section (hereinafter referred to as 'first charging') (S320). If the SOC of the battery 50 reaches the first target SOC, the first charging may be terminated. Depending on the embodiment, a condition for terminating the first charging may be determined by whether the charging voltage of the battery 50 reaches the first reference voltage, in addition to whether the SOC of the battery 50 reaches the first target SOC.

The control unit 140 may control the blocking unit 130, etc. so that charging of the second charging section does not proceed immediately following charging of the first charging section, but a rest period (first rest period) is provided for a predetermined time (S330).

The control unit 140 may determine whether the first rest period has elapsed from the time of controlling the blocking unit 130 (S340).

If the first rest period has elapsed, the control unit 140 may control the charging unit 120 to perform charging of the battery 50 in the second charging section (second charging) (S350). Specifically, the control unit 140 may control the charging unit 120 to charge the battery 50 according to the charging environment of the second charging section. As described above, the second charging may also be driven by a charging environment (one or more of the length of the charging section, the size of the charging current, and the charging rate) uniquely set for the second charging section itself.

The control unit 140 may determine whether the SOC of the battery 50 has reached the second target SOC through the second charge (S360). If the SOC of the battery 50 has reached the second target SOC, the second charge may be terminated.

The control unit 140 may control the blocking unit 130 to stop charging so that a second rest period occurs (S370).

The control unit 140 may determine whether the second rest period has elapsed from the time of controlling the blocking unit 130 (S380). As described above, a multistage charging method may be implemented by controlling charging and rest periods to alternately occur according to a plurality of charging sections.

Finally, the control unit 140 may control the charging unit 120 so that the battery 50 may be charged according to the charging environment of the final charging section (S390). Also, the control unit 140 may terminate the entire charging processing by the present disclosure when the SOC of the battery 50 reaches the final SOC (S395).

The charging processing described above may be sequentially performed from, for example, a complete discharge or an SOC level equivalent thereto to a full charge in the absence of a forced termination event, and it is preferable that the discharge processing is configured to be appropriately combined and applied according to the discharge pulse application in the rest period depending on the embodiment.

As described above, in the case of a conventional graphite-based negative electrode, the potential approaches lithium during charging, and lithium may be precipitated on the surface of the active material during the quick charging (QC) process.

In contrast, when the negative electrode is made of a composition such as Si, SiOx, or Sn, there is an advantage in that the potential during charging is higher than that of graphite-based negative electrode materials, which significantly reduces the possibility of lithium precipitation. However, due to volume expansion of the Si-based active material, the smooth flow or movement of lithium ions is impeded, and degradation may be concentrated mainly in the active material distributed in the upper layer adjacent to the separator.

However, when the charging processing according to an embodiment of the present disclosure described above is applied, a spontaneous reaction in which lithium in the upper active material moves toward the lower active material may be induced three-dimensionally, so that overall homogenization of lithium ions may be more easily implemented.

Additionally, each charging section may be controlled to be terminated when the voltage of the battery 50 reaches a reference voltage, unless the corresponding charging section is a section in which the battery 50 is fully charged. In other words, each charging step may be configured to be terminated when the voltage of the battery 50 reaches a reference voltage preset for the corresponding charging section. That is, when the voltage of the battery 50 reaches a reference voltage preset for the corresponding charging section, the control unit 140 may control the blocking unit 130 to initiate a rest period.

In this case, it is preferable that the reference voltage is set to be lower than the maximum voltage (e.g., charge termination voltage or full charge voltage) of the battery 50. With such an embodiment, the phenomenon in which the distribution of lithium ions is extremely biased toward the upper layer may be reduced, so that a spontaneous reaction in which lithium in the upper layer active material moves toward the lower layer active material may be more effectively induced.

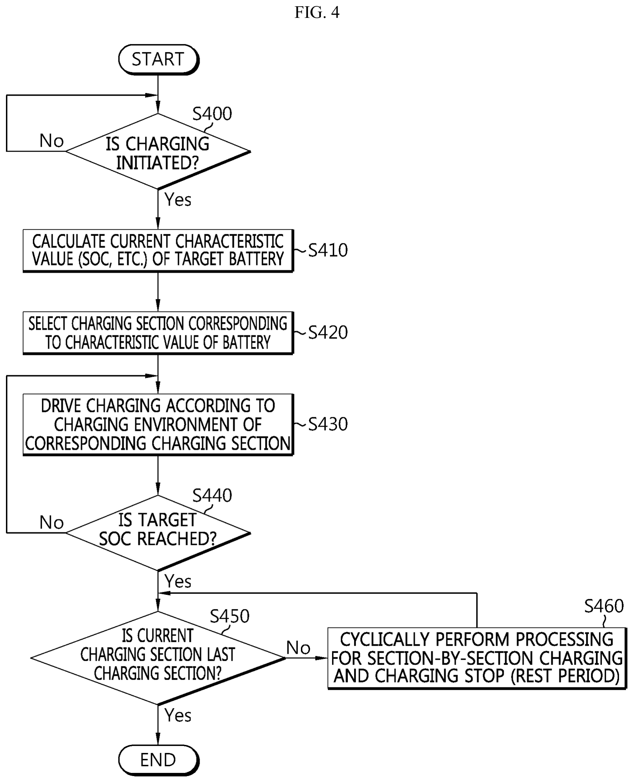

FIG. 2 is a block diagram showing the detailed configuration of a control unit illustrated in FIG. 1, and FIG. 4 is a flowchart showing a charging processing process according to another embodiment of the present disclosure.

As illustrated in FIG. 2, the control unit 140 of the present disclosure may be specifically configured to include a characteristic value calculating part 141, an attribute information storing part 143, a section determining part 145, and a main control part 147. As discussed above, each component of the control unit 140 illustrated in FIG. 2 may also correspond to a logical configuration.

Specifically, the embodiment of FIG. 4 is an embodiment in which the control unit 140 determines the current SOC of the battery 50 in each charging step and proceeds with charging in the charging section corresponding to the current SOC.

In order to implement the embodiment illustrated in FIG. 4, the attribute information for each of the plurality of charging sections is stored in the attribute information storing part 143, which is a component of the control unit 140. This attribute information includes information on the charging environment of each charging section as well as information on the range of the SOC that each charging section is responsible for.

As described above, when a signal for charging initiation is input, charging of the battery 50 may be initiated (S400).

The characteristic value calculating 141 may calculate the current SOC of the battery 50 using the electrical characteristic value (voltage, etc.) of the battery 50 sensed from the detecting unit 150 (S410).

When data on the current SOC of the battery 50 is entered, the section determining part 145 may select an initiation section, which is a charging section corresponding to the current SOC among the plurality of charging sections, by using the attribute information stored in the attribute information storing part 143 (S420).

The main control part 147 may control the charging unit 120 to initiate charging according to the charging environment (charging rate, size of charging current, etc.) of the selected initiation section (S430).

The main control part 147 may determine whether the SOC of the battery 50 reaches the target SOC according to the corresponding charging section (S440).

If the SOC of the battery 50 reaches the target SOC, the main control part 147 may determine whether the current charging section is the last charging section among the preset plurality of charging sections (S450).

If the current charging section is not the last charging section, the main control part 147 may control the charging unit 120 and the blocking unit 130 to perform processing for section-by-section charging and the rest period cyclically as described with reference to FIG. 3, etc. (S460).

Conversely, if the current charging section is the last charging section, the main control part 147 may control the charging unit 120 and the blocking unit 130 to terminate the charging processing of the battery 50.

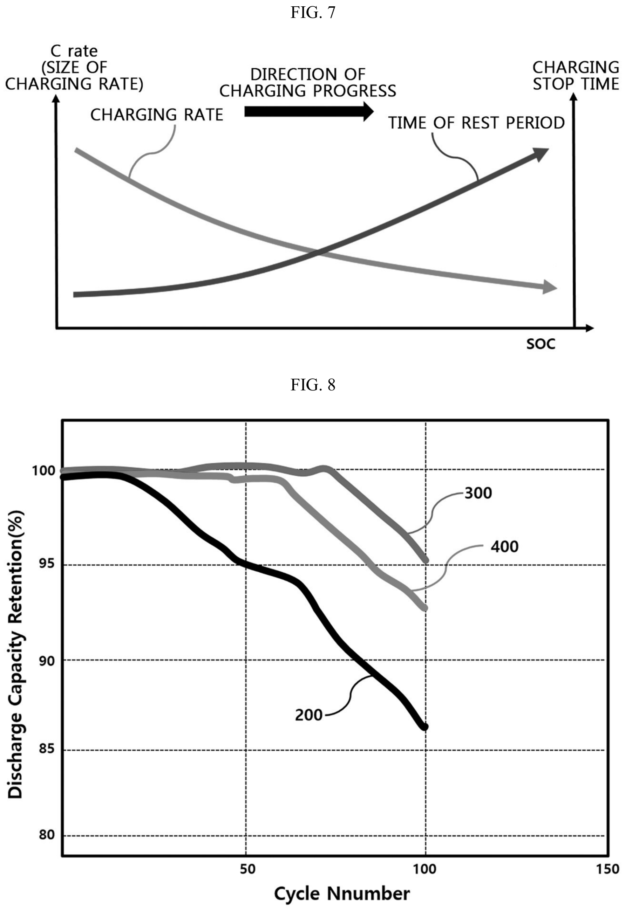

FIG. 5 is a drawing showing an example of a rest period in which the application time is differentiated, and FIG. 7 is a drawing showing the time-series characteristics of the charging rate and rest period based on the entire charging process.

As illustrated in FIG. 5, the rest period applied between the plurality of charging sections is configured such that its time increases as it progresses to a subsequent rest period based on the order in which charging is performed.

Assuming that the entire charging is performed in 5 charging sections, the rest period is not applied after the last charging section. That is, assuming that the rest period is applied between both the current charging section and the next charging section, the first rest period is applied between the first charging section and the second charging section, the second rest period is applied between the second charging section and the third charging section, the third rest period is applied between the third charging section and the fourth charging section, and finally, the fourth rest period is applied between the fourth charging section and the fifth charging section based on the time series order of charging.

In the embodiment of FIG. 5, the time (T2) of the second rest period (between #2 charging section and #3 charging section) is longer than the time (T1) of the first rest period (between #1 charging section and #2 charging section), and the time (T3) of the third rest period (between #4 charging section and #3 charging section) is longer than the time (T2) of the second rest period.

Assuming that the rest period is not applied after the last charging section, the final rest period is the rest period between the last charging section and the charging section immediately preceding the last charging section, and the time (T_{F}) of the final rest period is configured to be longer than the time (T_{F-1}) of the rest period immediately preceding the final rest period.

The progress of charging means that the SOC of the battery 50 increases, and the increase in SOC means that the concentration gradient phenomenon of lithium ions may occur more widely. Therefore, the present disclosure may more easily and clearly implement the homogenization of lithium ions throughout the entire charging process of the battery 50 by setting the time (rest period) for which a spontaneous reaction in which lithium in the upper active material moves toward the lower active material is induced to a length corresponding to the increased SOC in the charging process.

As illustrated in FIG. 7, as charging progresses through the plurality of charging sections, the charging rate of the corresponding charging section decreases as the SOC of the battery 50 increases, and the rest period is configured to become longer.

FIG. 8 is a diagram showing the performance results of the battery according to an embodiment of the present disclosure based on the discharge capacity retention. As is well known, a battery has a behavior characteristic in which its discharge capacity retention decreases as use (charging and discharging) continues or is repeated.

The first graph 200 of FIG. 8 is a comparative example for the present disclosure, and is a graph of battery behavior characteristics under conditions where the charging rate decreases as the charging section progresses, and the rest period between charging sections is fixed at 6 seconds.

The second graph 300 of FIG. 8 is an embodiment of the present disclosure, which is a graph of battery behavior characteristics under conditions where the charging rate decreases as the charging section progresses, and the rest period between charging sections gradually increases.

The charging environment conditions for the first graph 200 of FIG. 8 are as shown in Table 1 below, and the charging environment conditions for the second graph 300 of FIG. 8 are as shown in Table 2 below.

**[Table 1]**

| **QUICK CHARGING ENVIRONMENT CONDITION BY COMPARATIVE EMBODIMENT** | | | | | |
|---|---|---|---|---|---|
| **#** | **C rate** | **Time(min)** | **Capacity(mAh)** | **dSOC(%)** | **Rest Time(sec)** |
| 1 | 4 | 3.75 | 248.60 | 25 | 6 |
| 2 | 3.75 | 2.00 | 124.30 | 12.5 | 6 |
| 3 | 3.14 | 1.74 | 90.49 | 9.1 | 6 |
| 4 | 2.59 | 2.25 | 96.85 | 9.74 | 6 |
| 5 | 2.06 | 2.62 | 89.60 | 9.01 | 6 |
| 6 | 1.66 | 2.40 | 66.13 | 6.65 | 0 |
| **SUM (min)** | | **14.76** | | | **0.5 (min)** |
| **Total time (min)** | | **15.26** | | | |

**[Table 2]**

| **QUICK CHARGING ENVIRONMENT CONDITION BY EMBODIMENT** | | | | | |
|---|---|---|---|---|---|
| **#** | **C rate** | **Time(min)** | **Capacity(mAh)** | **dSOC(%)** | **Rest Time(sec)** |
| 1 | 4 | 3.75 | 248.60 | 25 | 2 |
| 2 | 3.63 | 2.06 | 124.30 | 12.5 | 4 |
| 3 | 3.08 | 1.77 | 90.49 | 9.1 | 6 |
| 4 | 2.59 | 2.25 | 96.85 | 9.74 | 8 |
| 5 | 2.09 | 2.59 | 89.60 | 9.01 | 10 |
| 6 | 1.71 | 2.34 | 66.13 | 6.65 | 0 |
| **SUM (min)** | | **14.76** | | | **0.5 (min)** |
| **Total time (min)** | | **15.26** | | | |

The total time required for the charging process of the first graph 200 and the second graph 300, i.e., the sum of the total time of each charging section by the 6 sections (14.76 minutes) and the total time of each rest period (30 seconds/0.5 minutes) are all 15.26 minutes, which is the same.

As shown in FIG. 8, in the case of the second graph 300 to which processing according to a preferred embodiment of the present disclosure is applied, it may be confirmed that the durability and performance retention of the battery itself are significantly improved as the performance degradation is significantly delayed or slowed down compared to the first graph 200.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

The drawings or the like attached for explaining the present disclosure and illustrating examples thereof may be illustrated in a somewhat exaggerated form in order to emphasize or highlight the technical content of the present disclosure. However, it should be interpreted that it is obvious that various modified examples are possible at the level of a person skilled in the art by considering the previously described content and matters illustrated in the drawings.

In addition, it is self-evident that expressions such as first, second, upper, lower, or top and bottom in the explanation of the present disclosure are merely instrumental concept terms used to relatively distinguish components (elements) from each other, and are not terms used to indicate a specific order, priority, or the like, or terms used to physically distinguish each component (element) on an absolute basis.

### [Explanation of reference signs]

100: apparatus for charging a battery
110: interface unit
120: charging unit
130: blocking unit
140: control unit
141: characteristic value calculating part
143: attribute information storing part
145: section determining part
147: main control part
150: detecting unit

## Claims

1. A method for charging a battery by dividing a charging section into a plurality of charging sections, the method comprising:
a first charging step for charging the battery in an nth (n is a natural number) charging section;
a first rest step having a rest period for a first time after the first charging step is terminated;
a second charging step for charging the battery in an n+1th charging section; and
a second rest step having a rest period for a second time after the n+1th charging section is terminated,
wherein the second time is set differently from the first time.

2. The method for charging a battery according to claim 1,
wherein the second time is set to be a longer time than the first time.

3. The method for charging a battery according to claim 1,
wherein a charging rate of the n+1th charging section is set to be lower than a charging rate of the nth charging section.

4. The method for charging a battery according to claim 1,
wherein each of the charging steps further includes:
a characteristic value calculating step for calculating a current SOC of the battery;
a section determining step for determining an initiation section, which is a charging section corresponding to the current SOC, among the plurality of charging sections; and
a charging initiating step for initiating charging of the battery with a charging environment of the initiation section.

5. The method for charging a battery according to claim 1,
wherein each of the charging steps is set to be terminated when a voltage of the battery reaches a reference voltage preset for the corresponding charging section.

6. The method for charging a battery according to claim 1,
wherein the method is configured to be terminated when a voltage of the battery reaches a preset full-charge voltage.

7. The method for charging a battery according to claim 1,
wherein the battery is a battery with a negative electrode of Si-based composition.

8. An apparatus for charging a battery, comprising:
a charging unit configured to charge a battery;
a blocking unit configured to block charging of the battery; and
a control unit configured to control the charging unit so that the battery is charged with a plurality of charging sections,
wherein the control unit is configured to control the blocking unit such that a rest period is included between the plurality of charging sections.

9. The apparatus for charging a battery according to claim 8,
wherein the control unit is configured to control the blocking unit so that an n+1th (where n is a natural number) rest period is longer than an nth rest period.

10. The apparatus for charging a battery according to claim 8,
wherein the control unit includes:
a characteristic value calculating part for calculating a current SOC of the battery;
an attribute information storing part for storing attribute information of the plurality of charging sections;
a section determining part for determining an initiation section, which is a charging section corresponding to the current SOC, using the attribute information; and
a main control part for controlling the charging unit so that charging of the battery is initiated with a charging environment of the initiation section.
